# EUROPÄISCHE PATENTSCHRIFT

(11) **EP 2 475 491 B1**
(45) Veröffentlichungstag und Bekanntmachung des Hinweises auf die Patenterteilung: **07.11.2018**
(21) Anmeldenummer: 10760213.8
(22) Anmeldetag: 09.09.2010
(51) Int. Cl.: B23K 9/32, G01R 31/36

(54) **VERFAHREN UND VORRICHTUNG ZUR ENERGIEUMWANDLUNG SOWIE SCHWEIßGERÄT**
ENERGY CONVERSION METHOD AND APPARATUS, AND WELDING DEVICE
PROCÉDÉ ET DISPOSITIF DE CONVERSION D'ÉNERGIE ET APPAREIL DE SOUDAGE

(30) Priorität: 10.09.2009 AT 14252009
(43) Veröffentlichungstag der Anmeldung: 18.07.2012
(73) Patentinhaber: Fronius International GmbH, 4643 Pettenbach (AT)
(72) Erfinder: MAGERL, Christian, A-3921 Langschlag (AT); BINDER, Jürgen, 4644 Scharnstein (AT); STIEGLBAUER, Walter, A-4901 Manning (AT); ARTELSMAIR, Bernhard, A-4643 Pettenbach (AT)
(74) Vertreter: Sonn & Partner Patentanwälte
(86) Internationale Anmeldenummer: PCT/AT2010/000323
(87) Internationale Veröffentlichungsnummer: WO 2011/029113

(56) Entgegenhaltungen:
- JP-A- 2000 209 784
- US-A- 6 051 957
- US-A1- 2007 181 547
- US-A1- 2009 008 374

## Beschreibung

Die Erfindung betrifft ein Verfahren zum Betreiben eines Schweißgeräts nach dem Oberbegriff des Patentanspruchs 1.

Weiters betrifft die Erfindung ein Schweißgerät mit einem Energiespeicher nach dem Oberbegriff des Patentanspruchs 5.

Um die Mobilität zu erhöhen, ist es allgemein bekannt, als Stromversorgung Energiespeicher zur Versorgung der Elektronik bzw. Leistungselektronik eines entsprechenden Geräts mit elektronischer Energie zu verwenden, sodass die Anwendung mit dem Gerät ausgeführt werden kann. Durch die begrenzte Energie des Energiespeichers muss dieser regelmäßig aufgeladen werden.

Der Einsatz von Energiespeichern bei Geräten zur Metallbearbeitung, wie bei Schweißgeräten, ist beispielsweise aus den Dokumenten DE 26 50 522 A1 und GB 2 316 244 A bekannt.

Die US 2005/0109748 A1 beschreibt ein Schweißgerät mit einem Energiespeicher zur Erzeugung der Schweißenergie bzw. des Lichtbogens. Die Spannung des Energiespeichers wird mit einem Hochsetzsteller auf eine Zwischenspannung transformiert, welche wiederum durch einen nachgeschalteten Tiefsetzsteller auf die für den Lichtbogen erforderliche Spannung herabgesetzt wird. Der Energiespeicher kann mit einem Ladegerät geladen werden. Das Ladegerät bildet eine eigenständige Einheit, welche entweder im Schweißgerät integriert oder als externe Einheit mit dem Energiespeicher verbunden werden kann. Nachteilig ist hierbei, dass die Energie für den Lichtbogen in zwei Schritten erzeugt wird, wodurch Schaltverluste sowohl im Hochsetzsteller als auch im Tiefsetzsteller auftreten, und dadurch der Wirkungsgrad gesenkt wird. Zusätzlich muss der Tiefsetzsteller die hochtransformierte Zwischenspannung auf die Lichtbogenspannung umwandeln, sodass aufgrund des größeren Spannungsunterschieds die Schaltverluste erhöht werden.

Die US 2009/008374 A1 und die US 2007/181547 beschreiben tragbare batteriebetriebene Schweißgeräte, bei welchen der Ladungszustand der Batterie angezeigt wird.

Auch die JP 10-272563 A und die JP 2003-028939 A beschreiben tragbare batteriebetriebene Schweißgeräte bei welchen für die Benutzer relevante Informationen über die Ladekapazität der Batterie zur Verfügung gestellt werden.

Die US 6,051,957 A beschreibt einen Energiespeicher für Mobiltelefone, Camcorder oder ähnliche elektronische Geräte mit einer Anzeige des Ladezustands und der verbleibenden Betriebszeit in Abhängigkeit des Betriebsmodus des elektronischen Geräts.

Schließlich ist aus der JP 2000-209784 A eine Schaltung bekannt geworden, mit Hilfe derer die verbleibende Ladung einer Batterie aus der Lade- bzw. Entladeinformation und der Spannung an der Batterie abgeleitet wird.

Die Aufgabe der vorliegenden Erfindung besteht in der Schaffung eines oben genannten Verfahrens zum Betreiben eines Schweißgeräts und eines dafür vorgesehenen Schweißgeräts, durch welche der Benutzer über den Zustand des Energiespeichers informiert werden kann und durch welche dem Benutzer eine optimale Energieverwaltung zur Nutzung der begrenzten Energie des Energiespeichers zur Verfügung gestellt werden kann. Nachteile bekannter Verfahren oder Vorrichtungen sollen vermieden oder zumindest reduziert werden.

Die Aufgabe der Erfindung wird durch ein oben genanntes Verfahren gelöst, bei dem bei Inbetriebnahme des Schweißgeräts über die Steuervorrichtung in Abhängigkeit einer ermittelten Kapazität des Energiespeichers und des an der Ein- und/oder Ausgabevorrichtung eingestellten Werts für den Schweißstrom vor der Durchführung eines Schweißprozesses ein Richtwert für die Restschweißzeit für das Betreiben des Schweißgeräts mit dem eingestellten Strom berechnet und angezeigt wird, die Restschweißzeit bei einer Veränderung des Schweißstroms an der Ein- und/oder Ausgabevorrichtung entsprechend korrigiert wird, und die Restschweißzeit während der Durchführung des Schweißprozesses aufgrund der Ist-Werte von Schweißstrom und Schweißspannung angepasst wird. Die Restschweißzeit ist jene Zeit, welche dem Schweißer bei eingestelltem Strom noch zur Verfügung steht. Vorteilhaft ist hierbei, dass der Benutzer bei Inbetriebnahme bereits die erste Information bekommt, wie lange der Energiespeicher noch genutzt werden kann, also wie lange man noch schweißen kann. Diese auf einem berechneten Wert basierende Information wird während des Durchführens des Schweißprozesses, also während des Energieverbrauchs, angepasst bzw. hochgerechnet und angezeigt.

Wenn die Anpassung des Werts der Restschweißzeit in definierten Zeitabständen durchgeführt wird und der jeweilige Wert der Restschweißzeit gespeichert wird, kann bei Inbetriebnahme bzw. Veränderung des Stroms zum Durchführen des Schweißprozesses aufgrund der gespeicherten Werte eine wesentlich genauere Berechnung erfolgen.

Von Vorteil ist auch die Verwendung von Energiespeichern mit Controllern, wodurch die Genauigkeit der Berechnungen erhöht wird.

Die erfindungsgemäße Aufgabe wird auch durch ein oben genanntes Schweißgerät gelöst, bei dem die Steuervorrichtung zur Berechnung eines Richtwerts der Restschweißzeit für die Durchführung eines Schweißprozesses in Abhängigkeit einer ermittelten Kapazität des Energiespeichers und des an der Ein- und/oder Ausgabevorrichtung vor der Durchführung des Schweißprozesses eingestellten Werts für den Schweißstrom, zum entsprechenden Korrigieren der Restschweißzeit bei einer Veränderung des Schweißstroms an der Ein- und/oder Ausgabevorrichtung und zum Anpassen der berechneten Restschweißzeit während der Durchführung des Schweißprozesses aufgrund der Ist-Werte von Schweißstrom und Schweißspannung ausgebildet ist, und eine Anzeige zum Anzeigen des berechneten Werts der Restschweißzeit vorgesehen ist. Die sich daraus ergebenden und weiteren Vorteile können aus den bereits beschriebenen Vorteilen und der nachfolgenden Beschreibung entnommen werden.

Die vorliegende Erfindung wird anhand der beigefügten, schematischen Zeichnungen näher erläutert. Darin zeigen:
- Fig. 1: eine schematische Darstellung eines Schweißgeräts;
- Fig. 2: ein schematisches Blockschaltbild einer Vorrichtung zur Umwandlung der Energie eines Energiespeichers zum Betreiben eines Lichtbogens;
- Fig. 3: ein Schaltbild einer derartigen Umschaltvorrichtung; und
- Fig. 4: und 5 schematische Darstellungen einer Ein- und/oder Ausgabevorrichtung eines erfindungsgemäß ausgebildeten Schweißgeräts.

Einführend wird festgehalten, dass gleiche Teile des Ausführungsbeispiels mit gleichen Bezugszeichen versehen werden.

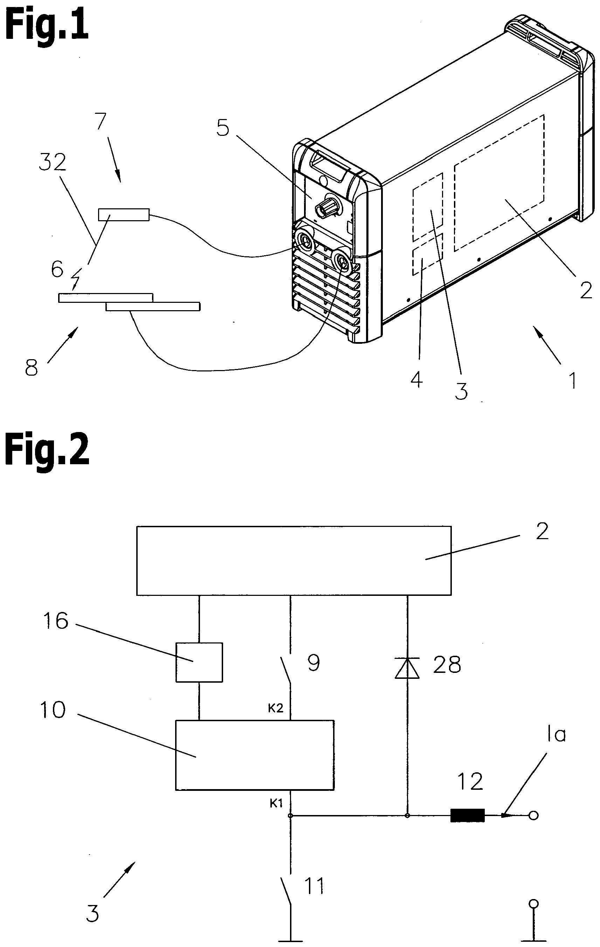

In Fig. 1 ist ein Gerät 1 gezeigt, welches zumindest einen Energiespeicher 2, einen Leistungsteil 3, eine Steuervorrichtung 4 und eine Ein- und/oder Ausgabevorrichtung 5 umfasst. Das Gerät 1 ist zur Bildung eines Lichtbogens 6 ausgebildet, welcher von der Steuervorrichtung 4 geregelt wird. Somit kann das Gerät 1 beispielsweise als Schweißgerät, Schneidgerät, Reinigungsgerät oder Lötgerät eingesetzt werden. Auf Details derartiger Geräte 1, wie beispielsweise die Kühlung eines Brenners 7, wird nicht näher eingegangen, da dies allgemein aus dem Stand der Technik bekannt ist.

Der Strom für den Lichtbogen 6 wird zwischen einer im Brenner 7 angeordneten bzw. mit einem Elektrodenhalter gehaltenen Elektrode 32 und einem Werkstück 8 aufgebaut. Das Werkstück 8, welches aus mehreren Teilen gebildet ist, ist dazu ebenfalls mit dem Gerät 1 verbunden. Entsprechend wird der Strom vom Leistungsteil 3 zur Verfügung gestellt, welcher vom Energiespeicher 2 versorgt wird. Des Weiteren kann der Strom und gegebenenfalls weitere Parameter an der Ein- und/oder Ausgabevorrichtung 5 eingestellt bzw. geregelt werden. Dazu ist die Ein- und/oder Ausgabevorrichtung 5 mit der Steuervorrichtung 4 verbunden. Bevorzugt ist der Leistungsteil 3 am Ausgang mit Anschlüssen bzw. Buchsen versehen, über welche der Brenner 7 bzw. das Werkstück 8 verbunden werden kann. Somit wandelt der Leistungsteil 3 die im Energiespeicher 2 gespeicherte Energie derart um, dass beispielsweise ein Schweißprozess durchgeführt werden kann, wie im folgenden Ausführungsbeispiel beschrieben wird.

Die durch den Energiespeicher 2 begrenzt zur Verfügung stehende Energie wird mit minimalen Schaltverlusten dem Lichtbogen 6 zur Verfügung gestellt, indem als Leistungsteil 3 ein Tiefsetzsteller zum Betreiben des Lichtbogens 6 verwendet wird und die Umschaltvorgänge zumindest eines mit dem Energiespeicher 2 verbundenen Schalters 9 des Tiefsetzstellers entlastet durchgeführt werden. Dazu wird in den Tiefsetzsteller eine Entlastungsschaltung 10 zur Durchführung entlasteter Umschaltvorgänge integriert.

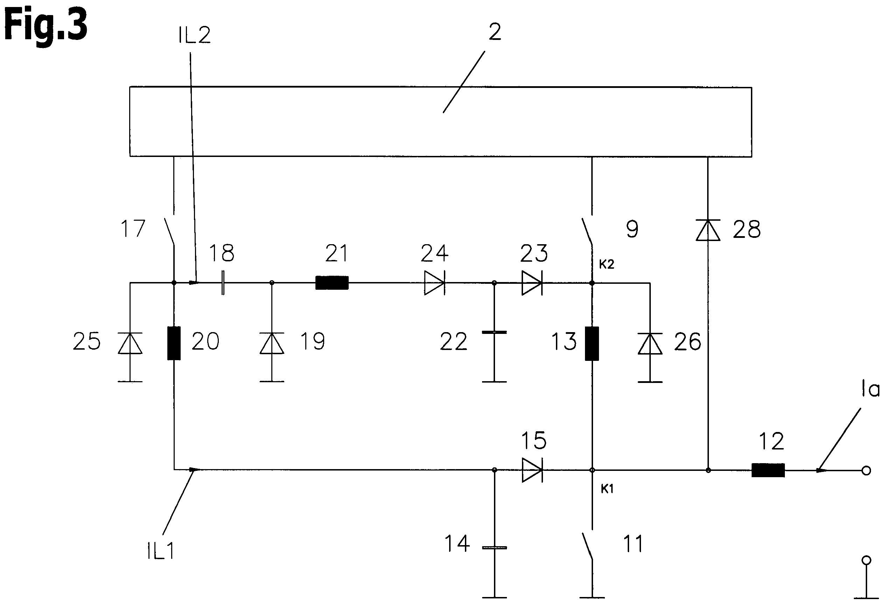

Der Leistungsteil 3 mit der integrierten Entlastungsschaltung 10 wird nun im Folgenden anhand der Fig. 2 und 3 beschrieben. Die Grundkomponenten des Tiefsetzstellers sind die Schalter 9 und 11 und die Drossel 12. Dabei spricht man auch von einem Synchronwandler, welcher als Synchrontiefsetzsteller eingesetzt wird. Um damit effizient, also mit einem Wirkungsgrad im Bereich von 99%, die Energie für den Lichtbogen 6 erzeugen zu können, wird der Schalter 9 derart mit der Entlastungsschaltung 10 beschaltet, dass sowohl eine Einschaltentlastung bei den Einschaltvorgängen als auch eine Ausschaltentlastung bei den Ausschaltvorgängen resultiert. Dadurch wird äußerst wenig Energie in Wärme umgewandelt und es ist daher lediglich eine minimale Kühlung der Elektronik des Leistungsteils 3 erforderlich. Somit wird auch der Platzbedarf des Leistungsteils 3 auf ein Minimum reduziert. In diesem Ausführungsbeispiel wird die Entlastungsschaltung 10 mit Speicherkomponenten, wie Kondensatoren und Drosseln, sowie Dioden realisiert. Allgemein regeln die Dioden die Stromrichtungen, wodurch die Energie des Energiespeichers 2 mit minimalen Schaltverlusten bei den Umschaltvorgängen zumindest des Schalters 9, in die für den Lichtbogen 6 eines Schweißprozesses, Schneidprozesses oder Reinigungsprozesses erforderliche Energie umgewandelt werden kann.

Die Einschaltentlastung ist dabei in zwei Beschaltungen unterteilt, wobei eine erste Beschaltung durch die Drossel 13 in Serie zum Schalter 9 gebildet ist und eine zweite Beschaltung durch den Kondensator 14 und die Diode 15 besteht. Die zweite Beschaltung wird von einer Steuereinheit 16 aktiv geregelt. Die erste Beschaltung wird indirekt über die zweite Beschaltung aktiv geregelt, sodass in Summe eine aktive Einschaltentlastung resultiert.

Die Steuereinheit 16 wird in ihrer einfachsten Form durch einen Schalter 17 gebildet, welcher wie der Schalter 9 eingangsseitig mit dem Energiespeicher 2 verbunden ist. In diesem Fall wird auch der Schalter 17 entsprechend entlastet. Konkret erfolgt über den Kondensator 18 und die Diode 19 eine Ausschaltentlastung und über die Drosseln 20 und 21 eine Einschaltentlastung.

Die Ausschaltentlastung für den Schalter 9 erfolgt ähnlich wie für den Schalter 17 über den Kondensator 22 und die Diode 23. Dabei verhindert die Diode 23 während des eingeschalteten Schalters 9 eine unkontrollierte Ladung des Kondensators 22 über den Schalter 9.

Eine Entlastung für den Schalter 11 ist nicht erforderlich, da dies automatisch aus dem grundsätzlichen Funktionsprinzip des Synchrontiefsetzstellers resultiert, wie allgemein aus dem Stand der Technik bekannt.

Die Funktion der Einschalt- und Ausschaltentlastung bei den Umschaltvorgängen, welche von der Steuervorrichtung 4 des Schweißgeräts 1 gemäß der Regelung des Synchronwandlers aktiv geregelt werden, wird ausgehend von folgender Ausgangssituation im Detail beschrieben:
Schalter 9 offen; Schalter 11 geschlossen; Kondensatoren 14, 18 und 22 sowie die Drosseln 20, 21 und 13 entladen.
Gemäß dieser Ausgangssituation wird der Ausgangsstrom Ia bzw. die Schweißenergie über den durch den Schalter 11 und die Drossel 12 gebildeten Stromkreis geliefert, wobei die Spannung am Schalter 11 im Wesentlichen Null ist. Demnach wird die Drossel 12 entladen. Damit im nächsten Schritt die Drossel 12 wieder geladen wird, wird der Schalter 9 eingeschaltet und der Schalter 11 entlastet ausgeschaltet.

Beim Einschalten des Schalters 9 wirkt die Einschaltentlastung, sodass im Einschaltaugenblick nur die Eigenkapazität des Schalters 9 umgeladen werden muss. Somit resultieren lediglich geringe, fast vernachlässigbare Einschaltverluste. Erreicht wird dies durch die in Serie zum Schalter 9 geschaltete Drossel 13, welche den Stromanstieg im Einschaltaugenblick derart begrenzt, dass der Stromanstieg kontinuierlich entsprechend der Dimensionierung der Drossel 13 erfolgt. Somit werden die minimalen Schaltverluste nur durch einen Bruchteil des Ausgangsstroms Ia verursacht.
Dieser Stromanstieg setzt sich solange fort, bis der Strom durch die Drossel 13 so groß wie der Ausgangsstrom Ia ist. Das heißt, dass der Ausgangsstrom Ia durch die Strombegrenzung zeitverzögert vollständig durch den Schalter 9 zum Ausgang fließt. Somit fließt kein Strom mehr über eine parallel zum Schalter 11 geschaltete Diode 15 zum Ausgang, sodass eine Kapazität 14 parallel zum Schalter 11 umgeladen wird. Im einfachsten Fall sind diese Diode 15 und diese Kapazität 14 Teil eines Leistungstransistors, welcher den Schalter 11 bildet. Dabei erfolgt die Umladung über die in Serie zu dieser Kapazität 14 geschaltete Drossel 13. Dies bewirkt, dass die Spannung am Knotenpunkt K1 zeitverzögert und kontinuierlich bzw. langsam bis zur Versorgungsspannung - also der Spannung des Energiespeichers 2 - ansteigt.
Durch diese langsame Spannungserhöhung werden des Weiteren sowohl am Schalter 9 als auch am Schalter 11 Spannungsspitzen vermieden, sodass ein kurzzeitiges, ungewolltes Umschalten des Schalters 9 bzw. 11 verhindert wird. Insbesondere wird verhindert, dass bei eingeschaltetem Schalter 9 auch der Schalter 11 eingeschaltet wird. Hierbei wird von einer sogenannten "Leitend-Phase" gesprochen, in welcher die Schweißenergie direkt vom Energiespeicher 2 geliefert wird. Dies ist der Fall, wenn am Knotenpunkt K1 die Versorgungsspannung anliegt.

Während der "Leitend-Phase" müssen entsprechende Vorbereitungen für die folgende Ausschaltentlastung und ebenso für die nächste Einschaltentlastung getroffen werden. In einer während der "Leitend-Phase" stattfindenden "Auflade-Phase" werden die Kondensatoren 14, 18 und 22 geladen, indem die Steuereinheit 16 aktiviert, also der Schalter 17 eingeschaltet wird. Der erste mögliche Zeitpunkt zur Aktivierung der Steuereinheit 16 ist jener, wenn am Knotenpunkt K1 die Versorgungsspannung anliegt. Der Schalter 17 bleibt solange eingeschaltet, bis am Kondensator 14 die halbe Versorgungsspannung anliegt. Des Weiteren werden die kleiner als der Kondensator 14 dimensionierten Kondensatoren 22 und 18 während dieser Zeit über die Drossel 21 und die Diode 24 vollständig geladen. Diese Drossel 21 und Diode 24 sind zwischen dem Kondensator 18 und dem Kondensator 22 angeordnet, sodass beide Kondensatoren 18, 22 mit dem selben Ladestrom IL2 geladen werden. Dabei regelt die Drossel 21 die Ladezeit von den gleich großen Kondensatoren 18 und 22, sodass diese gleichzeitig und identisch auf die Versorgungsspannung geladen werden. Die Kondensatoren 18 und 22 werden dabei höchstens in einer Zeit geladen, welche zum Erreichen der halben Versorgungsspannung am Kondensator 14 erforderlich ist. Dementsprechend erfolgt die Dimensionierung der Drossel 21. Des Weiteren bewirken die Drossel 21 und die Diode 24, dass beim Laden der Kondensatoren 18 und 22 diese in Serie geschaltet sind. Zur Erfüllung der Ausschaltentlastung arbeiten hingegen der Kondensator 18 und die Diode 19 bzw. der Kondensator 22 und die Diode 23 unabhängig voneinander.

Während dieser Zeit wird ebenso in der in Serie zum Schalter 17 geschalteten Drossel 20 entsprechend dem Ladestrom IL1 des Kondensators 14 Energie gespeichert.

Der Schalter 17 wird ausgeschaltet, nachdem die Kondensatoren 18 und 22 vollständig geladen wurden und am Kondensator 14 die halbe Versorgungsspannung anliegt. Der geladene Kondensator 18 und die Diode 19 dienen dabei als Ausschaltentlastung für den Schalter 17, da durch den Kondensator 18 im Schaltaugenblick die Versorgungsspannung auch ausgangsseitig des Schalters 17 anliegt und dadurch der Schalter 17 im Wesentlichen spannungsfrei bzw. ohne Potentialunterschied ausgeschaltet bzw. geöffnet werden kann. Die vollständige Entladung des Kondensators 18 erfolgt anschließend über die Drossel 20 zum Kondensator 14 bzw. zum Ausgang. Somit geht durch die Drossel 21, die Diode 19 und die Diode 25 diese zwischengespeicherte Energie nicht verloren. Der Kondensator 18 wird entladen, während der Kondensator 22 weiterhin auf der Versorgungsspannung gehalten wird.

Mit dem Ausschalten des Schalters 17 wird der Kondensator 14 mit der in der Drossel 20 gespeicherten Energie bis zur Versorgungsspannung aufgeladen. Dies erfolgt über den durch die Drossel 20, den Kondensator 14 und die Diode 25 gebildeten Stromkreis. Die Drossel 20 ist derart dimensioniert, dass während der Einschaltzeit des Schalters 17 genügend Energie gespeichert wird, um bei ausgeschaltetem Schalter 17 den Kondensator 14 auf die Versorgungsspannung aufzuladen.

Schließlich ist mit dem Erreichen der Versorgungsspannung am Kondensator 14 auch die "Auflade-Phase" während der "Leitend-Phase" beendet. Somit kann auch die "Leitend-Phase" beendet werden, da die Ausschaltentlastung für den Schalter 9 gewährleistet ist. Zusätzlich ist auch die Entnahme der Energie aus der Drossel 13 gewährleistet, sodass im Wesentlichen gleichzeitig mit dem Ausschalten des Schalters 9 auch die Einschaltentlastung für den nächsten Einschaltvorgang des Schalters 9 zur Verfügung steht.

Beim Ausschalten des Schalters 9 erfolgt die Ausschaltentlastung wie beim Schalter 17, indem durch den geladenen Kondensator 22 und über die Diode 23 auch ausgangsseitig am Schalter 9 bzw. am Knotenpunkt K2 die Versorgungsspannung zur Verfügung steht, sodass im Wesentlichen kein Spannungsabfall bzw. Potentialunterschied am Schalter 9 resultiert und dieser daher nahezu verlustfrei ausgeschaltet werden kann.

Somit fließt auch kein Strom mehr vom Energiespeicher 2 über den Schalter 9 in die Drossel 13, sodass auch die darin gespeicherte Energie im Wesentlichen vollständig entladen werden kann. Dies erfolgt derart, dass durch das vollständige Entladen des Kondensators 22 die Spannung am Knotenpunkt K2 kontinuierlich über die Diode 23 zum Ausgang sinkt. Ebenso wird mit dem Ausschalten des Schalters 9 auch der Kondensator 14 entladen, welcher die Spannung am Knotenpunkt K1 beeinflusst. Dabei sinkt die Spannung am Knotenpunkt K1 durch den gegenüber dem Kondensator 22 größeren Kondensator 14 langsamer als am Knotenpunkt K2. Dadurch wird auf der Drossel 13 eine sogenannte negative Spannungs-Zeit-Fläche aufgebracht, wodurch der Strom durch die Drossel 13 sinkt, da sich die Polarität der Spannung an der Drossel 13 aufgrund des früher entladenen Kondensators 22 umkehrt. Somit ist das Potential am Knotenpunkt K2 bzw. ausgangsseitig des Schalters 9 nach dem Entladen des Kondensators 22 im Wesentlichen Null, wobei dieses Potential am Knotenpunkt K2 durch die Diode 26 gehalten wird. Die negative Spannungs-Zeit-Fläche an der Drossel 13 bewirkt dabei, dass der aus der Entladung der Drossel 13 resultierende Strom dem Ausgang zugeführt wird. Somit wird die Energie der Drossel 13 und des Kondensators 14 im Wesentlichen ohne Verluste dem Ausgangsstrom Ia zugeführt. Somit steht die Einschaltentlastung für den nächsten Einschaltvorgang des Schalters 9 wieder zur Verfügung. Entsprechend wird mit dem Ausschalten des Schalters 9 wiederum der Schalter 11 eingeschaltet, sodass der Ausgangsstrom Ia nicht unterbrochen wird. Konkret erfolgt dies, wenn am Knotenpunkt K1 die Spannung im Wesentlichen auf Null gesunken ist. Somit ist die Einschaltentlastung gegeben. Demnach ist wieder die Ausgangssituation hergestellt. Entsprechend wiederholt sich dies, solange Schweißenergie benötigt wird.

Da der Leistungsteil 3 insbesondere zur Bereitstellung von Schweißenergie aus einem Energiespeicher 2 eingesetzt wird, steht dem Anwender gemäß der Kapazität des Energiespeichers 2 eine begrenzte Energie zur Verfügung.

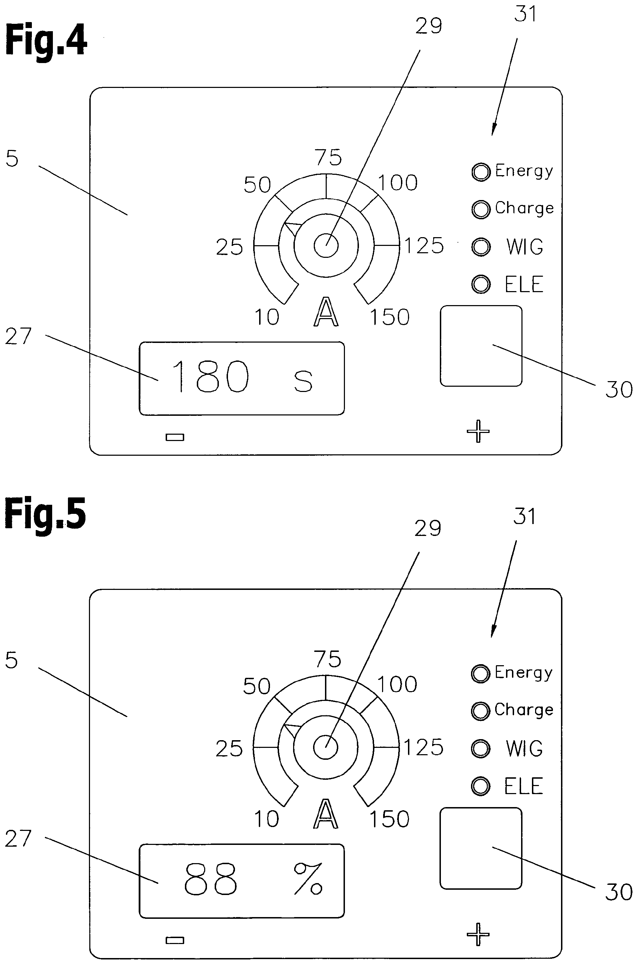

Erfindungsgemäß wird daher die zur Verfügung stehende Energie bzw. davon abgeleitete Parameter an einer Anzeige 27 gemäß den Fig. 4 und 5 an der Ein- und/oder Ausgabevorrichtung 5 angezeigt. Bevorzugt wird dazu aus der Kapazität des Energiespeichers 2 und dem mit dem Einstellorgan 28 eingestellten Strom für den Aufbau des Lichtbogens 6 eine Zeit berechnet, wie lange die Energie für diesen Strom ausreicht. Die Berechnung eines Parameters, insbesondere der zur Verfügung stehenden Zeit, also der Restzeit, erfolgt beispielsweise wie im Folgenden beschrieben. In Energiespeichern 2 gemäß dem Stand der Technik sind häufig sogenannte "State of Charge" (SOC)- und/oder "State of Health" (SOH)-Controller integriert. Diese Controller liefern entsprechend der Steuervorrichtung 4 des Geräts 1 insbesondere den aktuellen Ladezustand, welcher im Wesentlichen der Kapazität des Energiespeichers 2 entspricht. Des Weiteren ist der Steuervorrichtung 4 auch der eingestellte Strom für den Lichtbogen 6 bekannt. Dieser ist erforderlich, da die effektiv nutzbare Kapazität des Energiespeichers 2 stark von der Belastung abhängig ist. Die Belastung entspricht dabei dem eingestellten Strom. Beispielsweise ist bei einer Schweißung mit hohem Schweißstrom die Kapazität des Energiespeichers 2 schneller erschöpft, als bei einer Schweißung mit einem mittleren bzw. niedrigen Schweißstrom. Somit dienen die Kapazität des Energiespeichers 2 und der Strom zum Betreiben des Lichtbogens 6 als Grundbasis für die Berechnung.

Erfindungsgemäß wird bei Inbetriebnahme des Geräts 1 aus Strom und Kapazität jene Zeit, wie lange mit diesem eingestellten Strom gearbeitet werden kann, berechnet und an der Anzeige 27 angezeigt. Dabei spricht man von einer Restzeit bzw. bei einem Schweißgerät von einer sogenannten Restschweißzeit. Wird der Strom zum Betreiben des Lichtbogens 6, insbesondere der Schweißstrom, verändert, wird auch die Restschweißzeit entsprechend korrigiert. Da bei Inbetriebnahme eines Schweißgeräts noch kein Schweißprozess durchgeführt wurde, dient die angezeigte Restschweißzeit nur als Richtwert. Der tatsächliche Energieverbrauch ist dabei noch nicht berücksichtigt. Dieser ist insbesondere von der Länge des Lichtbogens 6, der verwendeten Schweißelektrode 32, der entsprechenden Schweißanwendung, usw. abhängig.
Wird nun ein Schweißprozess durchgeführt, berechnet die Steuervorrichtung 4 aufgrund der Istwerte von Schweißstrom und Schweißspannung bzw. Strom und Spannung des Energiespeichers 2 den tatsächlichen Energieverbrauch über eine bestimmte Zeit. Aufgrund dieses bisherigen Energieverbrauchs kann auf den zukünftigen Energieverbrauch hochgerechnet werden und somit die Restschweißzeit, wie lange noch geschweißt werden kann, korrigiert und der neue Wert an der Anzeige 27 angezeigt werden. Dies kann in regelmäßigen Zeitabständen, wie alle fünf, dreißig oder sechzig Sekunden, während des Betreibens des Lichtbogens 6 erfolgen. An der Anzeige 27 wird die zuletzt berechnete Restschweißzeit bevorzugt solange angezeigt, bis ein neuer Schweißprozess gestartet, der Schweißstrom verändert oder das Gerät 1 ausgeschaltet wird.

Weiters kann zumindest der letzte berechnete Wert gespeichert werden, sodass bei der nächsten Inbetriebnahme dieser Wert an der Anzeige 27 angezeigt wird.

Um die Berechnung der Restschweißzeit noch genauer durchführen zu können, werden beispielsweise die in regelmäßigen Zeitabständen erfassten Istwerte während eines Schweißprozesses gespeichert. Nach dem Schweißprozess kann somit die während des Schweißprozesses verbrauchte Energie daraus berechnet werden, wobei dieser Wert des Energieverbrauchs dem eingestellten Schweißstrom während des Schweißprozesses zugeordnet wird. Wird nun mehrmals mit demselben eingestellten Schweißstrom ein Schweißprozess durchgeführt, kann ein Mittelwert des Energieverbrauchs gebildet werden. Da entsprechend auch zu jedem durchgeführten Schweißprozess die dafür benötigte Schweißzeit gespeichert wird, kann auch diese gemittelt werden. Auf diese Weise kann sozusagen eine Bibliothek angelegt werden, in welcher beispielsweise zu einer Vielzahl von möglichen Einstellungen des Schweißstroms ein Mittelwert des Energieverbrauchs über eine definierte Zeit gespeichert ist. Dabei kann eine derartige Bibliothek mit jedem durchgeführten Schweißprozess entsprechend aktualisiert werden. Auf diese Weise wird erreicht, dass bei Inbetriebnahme des Schweißgeräts 1 bzw. bei Veränderung des Schweißstroms der durch den eingestellten Schweißstrom bedingte Energieverbrauch aus Erfahrungswerten aus der Bibliothek im Wesentlichen bekannt ist. Aus der Kapazität des Energiespeichers 2 und dem in der Bibliothek gespeicherten Energieverbrauch pro Schweißprozess kann somit berechnet werden, wieviele Schweißprozesse mit dem eingestellten Schweißstrom und der zur Verfügung stehenden Kapazität des Energiespeichers 2 durchgeführt werden können. Da in der Bibliothek entsprechend zum Energieverbrauch auch die dazugehörige Schweißzeit gespeichert wird, kann die Restschweißzeit berechnet und an der Anzeige 27 angezeigt werden.

Die Restschweißzeit wird also iterativ berechnet bzw. ermittelt, da die noch zur Verfügung stehende Energie und der aktuelle Energieverbrauch in regelmäßigen Zeitabständen berücksichtigt werden. Somit wird auch die an der Anzeige 27 angezeigte Restschweißzeit regelmäßig angepasst, sodass eine relativ genaue Information über den Energiespeicher 2 zur Verfügung steht.

Selbstverständlich kann die beschriebene Anzeige der Restschweißzeit auch für ähnliche Funktionen eingesetzt werden. Speziell ist dies der Fall, wenn der Energiespeicher 2 nicht mit einem Modul zum Schweißen kombiniert wird, sondern beispielsweise mit einem Wechselrichtermodul oder einem Werkzeugmodul.

Von Vorteil ist es weiters, wenn eine Möglichkeit des Ladens des Energiespeichers 2 besteht. Wenn als Leistungsteil 3 ein Synchrontiefsetzsteller eingesetzt wird, kann dieser auch zum Laden des Energiespeichers 2 eingesetzt werden, indem der Synchronwandler als Hochsetzsteller betrieben wird. Der Synchrontiefsetzsteller wird dabei in umgekehrter Richtung betrieben, indem Eingang und Ausgang vertauscht werden. Somit sind für den Betrieb des Hochsetzstellers gemäß Fig. 2 der Schalter 11, die Drossel 12 und die Diode 28 von Bedeutung. Wird die Funktion der Diode 28 durch einen Schalter ersetzt, spricht man von einem Synchronhochsetzsteller. Somit wird der Schalter 11 bei beiden Betriebsarten des Synchronwandlers eingesetzt, sodass für die jeweilige Betriebsart eine unterschiedliche Steuerung erforderlich ist. Beispielsweise wird die Steuerung des Schalters 11 zum Betrieb als Hochsetzsteller aktiviert, indem an der Ein- und/oder Ausgabevorrichtung 5 ein Lademodus (Charge) mit einem Einstellorgan 30 gemäß den Fig. 4 und 5 aktiviert wird. Der aktivierte Lademodus wird beispielsweise mit einer Leuchtdiode 31 gekennzeichnet.

Bei aktiviertem Lademodus ist also die Grundvoraussetzung gegeben, dass der Energiespeicher 2 geladen werden kann. Dazu ist es erforderlich, eine entsprechende Spannungsquelle anzuschließen. Dies erfolgt am Ausgang des Synchrontiefsetzstellers, welcher in diesem Fall als Eingang des Synchronhochsetzstellers dient. Konkret handelt es sich beim Ausgang um die Schweißbuchsen, wenn der Leistungsteil 3 in einem Schweißgerät eingesetzt wird. Als Spannungsquelle kann beispielsweise die Batterie eines Fahrzeugs herangezogen werden. Im Bereich der Schweißbuchsen kann ein Verpolschutz vorgesehen sein, sodass der Leistungsteil 3 beim Anschluss der Spannungsquelle geschützt wird.

Gemäß der allgemein bekannten Funktion eines Hochsetzstellers muss die Spannung der Spannungsquelle niedriger als die Spannung des Energiespeichers 2 sein.

Nachdem der Lademodus aktiviert und die Spannungsquelle angeschlossen wurde, wird der Energiespeicher 2 geladen. Dazu wird der Schalter 11 derart angesteuert, dass die Spannung der Spannungsquelle auf die Spannung des Energiespeichers 2 hochgesetzt wird. Der Ladestrom für den Energiespeicher 2 fließt entsprechend über die Diode 28 zum Energiespeicher 2, wobei die oben erwähnten allfälligen SOC- und/oder SOH-Controller eine gleichmäßige Ladung einzelner Zellen des Energiespeichers 2 gewährleisten. Der Ladezustand wird von den SOC- und/oder SOH-Controllern überwacht und der Steuervorrichtung 4 mitgeteilt. Somit kann beispielsweise an der Anzeige 27 der Ladezustand in Prozent angezeigt werden. Demzufolge wird der Ladevorgang automatisch von der Steuervorrichtung 4 beendet, sobald der Energiespeicher 2 vollständig geladen ist. Dies wird an der Ein- und/oder Ausgabevorrichtung 5 der Anzeige 27 oder mittels einer der Leuchtdioden 31 (Energy) entsprechend angezeigt. Beispielsweise leuchtet die Leuchtdiode 31 (Energy) rot, wenn der Energiespeicher 2 geladen werden muss, bzw. grün, wenn der Energiespeicher 2 vollständig geladen ist. Somit kann mit dem Einstellorgan 30 vom Lademodus beispielsweise wieder in den Schweißmodus (WIG od. ELE) gewechselt werden.

Selbstverständlich kann das Schweißgerät auch einen entsprechenden Anschluss aufweisen, über den der Energiespeicher 2 mit einem Ladegerät geladen werden kann. In diesem Fall ist die Betriebsart des Synchronwandlers als Hochsetzsteller nicht erforderlich.

Weiters ist es möglich, dass am Gerät 1, insbesondere Schweißgerät ein zusätzlicher Ausgang in Form einer Niederspannungssteckdose angeordnet ist, die bevorzugt parallel zu den Schweißausgängen bzw. Schweißbuchsen am Leistungsteil 3 angeschlossen ist, d.h. dass am Schweißgerät 1 ein Ausgang zum Versorgen zusätzlicher Verbraucher angeordnet ist. Somit können weitere Verbraucher, wie Lampen, Neonröhren, Trennschleifer, insbesondere Flex-Module, Klebepistolen, Bohrmaschinen bzw. Bohr-Module, Stichsägen bzw. Stichsäge-Module usw. angeschlossen werden.

Selbstverständlich kann im Gerät 1 bzw. Schweißgerät ein Hochsetzsteller und ein DC/AC-Modul angeordnet sein und somit der zusätzliche Ausgang als Wechselspannungsausgang, insbesondere als eine 240V- Steckdose, ausgebildet sein. Dabei können ein oder mehrere Niederspannungsausgänge und ein Wechselspannungsausgang am Gerät 1, insbesondere Schweißgerät, angeordnet werden und somit weitere Geräte, die mit entsprechender Spannung betrieben werden, direkt am Gerät 1 angeschlossen werden. Werden derartige Zusatzgeräte angeschlossen und verwendet, so kann, wie zuvor beschrieben, auch deren Energieverbrauch ermittelt und dargestellt werden. Hierzu ist es möglich, dass eine allgemeine Anzeige für die noch zur Verfügung stehende Energie und/oder eine Anzeige für die Zeitdauer eines oder mehrerer Schweißvorgänge vorhanden ist, sodass der Benutzer optimal die vorhandene Energie nützen kann.

Der Vorteil einer derartigen Ausstattung des Geräts 1 bzw. Schweißgeräts liegt darin, dass nunmehr der Benutzer ein Schweißgerät zum Verbinden von Materialien zur Verfügung hat, wo noch zusätzlich weitere Geräte für weitere Arbeiten, wie das Trennen von Materialien, angeschlossen werden können, wobei eine gemeinsame Stromversorgung vorhanden ist.

## Patentansprüche

1. Verfahren zum Betreiben eines Schweißgeräts (1) zur Bildung eines Lichtbogens (6) mit einem Energiespeicher (2), wobei zur Umwandlung der Energie des Energiespeichers (2) ein Leistungsteil (3) und eine mit einer Steuervorrichtung (4) verbundene Ein- und/oder Ausgabevorrichtung (5) zur Einstellung des Schweißstroms verwendet werden, **dadurch gekennzeichnet, dass** bei Inbetriebnahme des Schweißgeräts (1) über die Steuervorrichtung (4) in Abhängigkeit einer ermittelten Kapazität des Energiespeichers (2) und des an der Ein- und/oder Ausgabevorrichtung (5) eingestellten Werts für den Schweißstrom vor der Durchführung eines Schweißprozesses ein Richtwert für die Restschweißzeit für das Betreiben des Schweißgeräts (1) mit dem eingestellten Schweißstrom berechnet und angezeigt wird, die Restschweißzeit bei einer Veränderung des Schweißstroms an der Ein- und/oder Ausgabevorrichtung (5) entsprechend korrigiert wird, und die Restschweißzeit während der Durchführung des Schweißprozesses aufgrund der Istwerte von Schweißstrom und Schweißspannung angepasst wird.

2. Verfahren nach Anspruch 1, **dadurch gekennzeichnet, dass** die Anpassung des Werts der Restschweißzeit in definierten Zeitabständen durchgeführt wird und der jeweilige Wert der Restschweißzeit gespeichert wird.

3. Verfahren nach Anspruch 2, **dadurch gekennzeichnet, dass** der Wert der Restschweißzeit in Abhängigkeit gespeicherter Werte des Energieverbrauchs für den eingestellten Schweißstrom berechnet wird.

4. Verfahren nach einem der Ansprüche 1 bis 3, **dadurch gekennzeichnet, dass** die Kapazität des Energiespeichers (2) durch Abrufen zumindest eines Controllers des Energiespeichers (2) ermittelt wird.

5. Schweißgerät (1) mit einem Energiespeicher (2), einem Brenner (7) zur Bildung eines Lichtbogens (6), einer mit einer Steuervorrichtung (4) verbundenen Ein- und/oder Ausgabevorrichtung (5) zur Einstellung des Schweißstroms, und einem Leistungsteil (3) zur Umwandlung der Energie des Energiespeichers (2) zum Betreiben des Lichtbogens (6), **dadurch gekennzeichnet, dass** die Steuervorrichtung (4) zur Berechnung eines Richtwerts der Restschweißzeit für die Durchführung eines Schweißprozesses in Abhängigkeit einer ermittelten Kapazität des Energiespeichers (2) und des an der Ein- und/oder Ausgabevorrichtung (5) vor der Durchführung des Schweißprozesses eingestellten Werts für den Schweißstrom, zum entsprechenden Korrigieren der Restschweißzeit bei einer Veränderung des Schweißstroms an der Ein- und/oder Ausgabevorrichtung (5) und zum Anpassen der berechneten Restschweißzeit während der Durchführung des Schweißprozesses aufgrund der Istwerte von Schweißstrom und Schweißspannung ausgebildet ist, und eine Anzeige (27) zum Anzeigen des berechneten Werts der Restschweißzeit vorgesehen ist.

6. Schweißgerät (1) nach Anspruch 5, **dadurch gekennzeichnet, dass** die Steuervorrichtung (4) zur Berechnung des Werts der Restschweißzeit in definierten Zeitabständen ausgebildet ist und ein Speicher zum Speichern der jeweiligen Werte der Restschweißzeit vorgesehen ist.

7. Schweißgerät (1) nach Anspruch 5 oder 6, **dadurch gekennzeichnet, dass** zumindest ein Controller des Energiespeichers (2) vorgesehen ist, welcher zur Ermittlung der Kapazität des Energiespeichers (2) verwendbar ist.

8. Schweißgerät (1) nach einem der Ansprüche 5 bis 7, **dadurch gekennzeichnet, dass** eine Einrichtung zum Laden des Energiespeichers (2) vorgesehen ist.

9. Schweißgerät (1) nach Anspruch 8, **dadurch gekennzeichnet, dass** an der Ein- und/oder Ausgabevorrichtung (5) eine Leuchtdiode (31) zur Anzeige des Ladezustandes des Energiespeichers (2) vorgesehen ist.

10. Schweißgerät (1) nach Anspruch 8 oder 9, **dadurch gekennzeichnet, dass** an der Ein- und/oder Ausgabevorrichtung (5) ein Einstellorgan (30) zum Ein- und Ausschalten der Ladeeinrichtung vorgesehen ist.

## Claims

1. Method for operating a welding device (1) for forming an electric arc (6), the device comprising an energy accumulator (2), a power unit (3) and an input and/or output apparatus (5), connected to a control apparatus (4), for setting the welding current being used to convert the energy of the energy accumulator (2), **characterised in that** when the welding device (1) is started up, a reference value for the remaining welding time for operating the welding device (1) is calculated and displayed using the set welding current, by means of the control apparatus (4), on the basis of a determined capacitance of the energy accumulator (2) and the value set on the input and/or output apparatus (5) for the welding current before a welding process is carried out, the remaining welding time is correspondingly corrected when the welding current is changed on the input and/or output apparatus (5), and the remaining welding time is adapted while the welding process is being carried out on the basis of the actual value of the welding current and welding voltage.

2. Method according to claim 1, **characterised in that** the value of the remaining welding time is adapted at defined time intervals and the particular value of the remaining welding time is stored.

3. Method according to claim 2, **characterised in that** the value of the remaining welding time is calculated on the basis of stored values of the energy consumption for the set welding current.

4. Method according to any of claims 1 to 3, **characterised in that** the capacitance of the energy accumulator (2) is determined by querying at least one controller of the energy accumulator (2).

5. Welding device (1) comprising an energy accumulator (2), a welding head (7) for forming an electric arc (6), an input and/or output apparatus (5), connected to a control apparatus (4), for setting the welding current, and a power unit (3) for converting the energy of the energy accumulator (2) for operating the electric arc (6), **characterised in that** the control apparatus (4) is configured to calculate a reference value of the remaining welding time for carrying out a welding process on the basis of a determined capacitance of the energy accumulator (2) and the value for the welding current set on the input and/or output apparatus (5) before the welding process is carried out, to correspondingly correct the remaining welding time when the welding current is changed on the input and/or output apparatus (5) and to adapt the calculated remaining welding time while the welding process is being carried out on the basis of the actual value of the welding current and welding voltage, and a display unit (27) is provided for displaying the calculated value of the remaining welding time.

6. Welding device (1) according to claim 5, **characterised in that** the control apparatus (4) is configured to calculate the value of the remaining welding time at defined time intervals and a storage means is provided for storing the respective values of the remaining welding time.

7. Welding device (1) according to either claim 5 or claim 6, **characterised in that** at least one controller of the energy accumulator (2) is provided, which can be used to determine the capacitance of the energy accumulator (2).

8. Welding device (1) according to any of claims 5 to 7, **characterised in that** a device is provided for charging the energy accumulator (2).

9. Welding device (1) according to claim 8, **characterised in that** a light-emitting diode (31) is provided on the input and/or output apparatus (5) for displaying the charge state of the energy accumulator (2).

10. Welding device (1) according to either claim 8 or claim 9, **characterised in that** a setting element (30) is provided on the input and/or output apparatus (5) for switching the charging means on and off.

## Revendications

1. Procédé d'exploitation d'un appareil de soudure (1), pour la formation d'un arc électrique (6) avec un accumulateur d'énergie (2), une partie de puissance (3) étant utilisée pour la conversion de l'énergie de l'accumulateur d'énergie (2) et un dispositif d'entrée et/ou de sortie (5) relié avec un dispositif de commande (4) étant utilisé pour le réglage du courant de soudure, **caractérisé en ce que**, lors de la mise en service de l'appareil de soudure (1), par l'intermédiaire du dispositif de commande (4), en fonction d'une capacité déterminer de l'accumulateur d'énergie (2) et de la valeur, réglée sur le dispositif d'entrée et/ou de sortie (5), pour le courant de soudure avant la réalisation d'un processus de soudure, une valeur directrice pour le temps de soudure restant pour l'exploitation de l'appareil de soudure (1) avec le courant de soudure réglé est calculée est affichée, le temps de soudure restant étant corrigé en conséquence lors d'une modification du courant de soudure sur le dispositif d'entrée et/ou de sortie (5) et le temps de soudure restant étant adapté pendant la réalisation du processus de soudure sur la base des valeurs réelles du courant de soudure et de la tension de soudure.

2. Procédé selon la revendication 1, **caractérisé en ce que** l'adaptation de la valeur du temps de soudure restant est effectuée à des intervalles définis et la valeur correspondante du temps de soudure restant est enregistrée.

3. Procédé selon la revendication 2, **caractérisé en ce que** la valeur du temps de soudure restant est calculée en fonction des valeurs enregistrées de la consommation d'énergie pour le courant de soudure réglé.

4. Procédé selon l'une des revendications 1 à 3, **caractérisé en ce que** la capacité de l'accumulateur d'énergie (2) est déterminée par l'interrogation d'au moins un contrôleur de l'accumulateur d'énergie (2).

5. Appareil de soudure (1) avec un accumulateur d'énergie (2), un chalumeau (7) pour la formation d'un arc électrique (6), un dispositif d'entrée et/ou de sortie (5) relié à un dispositif de commande (4) pour le réglage du courant de soudure, et une partie de puissance (3) pour la conversion de l'énergie de l'accumulateur d'énergie (2) pour l'exploitation de l'arc électrique (6), **caractérisé en ce que** le dispositif de commande (4) est conçu pour le calcul d'une valeur directrice du temps de soudure restant pour la réalisation d'un processus de soudure en fonction d'une capacité déterminée de l'accumulateur d'énergie (2) et de la valeur réglée pour le courant de soudure avant la réalisation du processus de soudure sur le dispositif d'entrée et/ou de sortie (5), pour la correction en conséquence du temps de soudure restant lors d'une modification du courant de soudure sur le dispositif d'entrée et/ou de sortie (5) et pour l'adaptation du temps de soudure restant pendant la réalisation du processus de soudure sur la base des valeurs réelles du courant de soudure et de la tension de soudure, et un affichage (27) est prévu pour l'affichage de la valeur calculée du temps de soudure restant.

6. Appareil de soudure (1) selon la revendication 5, **caractérisé en ce que** le dispositif de commande (4) est conçu pour le calcul de la valeur du temps de soudure restant à des intervalles définis et une mémoire est prévue pour l'enregistrement des valeurs correspondantes du temps de soudure restant.

7. Appareil de soudure (1) selon la revendication 5 ou 6, **caractérisé en ce qu'**au moins un contrôleur de l'accumulateur d'énergie (2) est prévu, qui peut être utilisé pour déterminer la capacité de l'accumulateur d'énergie (2).

8. Appareil de soudure (1) selon l'une des revendications 5 à 7, **caractérisé en ce qu'**un dispositif de charge de l'accumulateur (2) est prévu.

9. Appareil de soudure (1) selon la revendication 8, **caractérisé en ce que**, sur le dispositif d'entrée et/ou de sortie (5), est prévue une diode électroluminescente (31) pour l'affichage de l'état de charge de l'accumulateur d'énergie (2).

10. Appareil de soudure (1) selon la revendication 8 ou 9, **caractérisé en ce que**, sur le dispositif d'entrée et/ou de sortie (5), est prévu un organe de réglage (30) pour la mise en marche et l'arrêt du dispositif de charge.
